# FASCICULE DE BREVET EUROPEEN

(11) **EP 3 844 979 B1**
(45) Date de publication et mention de la délivrance du brevet: **02.12.2026**
(21) Numéro de dépôt: 19779943.0
(22) Date de dépôt: 08.10.2019
(51) Int. Cl.: H04R 29/00, H03G 9/18, H04R 3/00

(54) **PROCÉDÉ ET DISPOSITIF DE CONTRÔLE DE LA DISTORSION D'UN SYSTÈME DE HAUT-PARLEURS EMBARQUÉ DANS UN VÉHICULE**
VERFAHREN UND VORRICHTUNG ZUR STEUERUNG DER VERZERRUNG EINES LAUTSPRECHERSYSTEMS AN BORD EINES FAHRZEUGES
METHOD AND DEVICE FOR CONTROLLING THE DISTORTION OF A LOUDSPEAKER SYSTEM ON BOARD A VEHICLE

(30) Priorité: 08.10.2018 FR 1859307
(43) Date de publication de la demande: 07.07.2021
(73) Titulaire: Arkamys, 75017 Paris (FR)
(72) Inventeur: SINEV, Daniil, 75014 PARIS (FR); ROSSI FERRARI, Guillaume, 92700 COLOMBES (FR); BOURMEYSTER, Ivan, 75015 PARIS (FR)
(74) Mandataire: Santarelli
(86) Numéro de dépôt international: PCT/EP2019/077237
(87) Numéro de publication internationale: WO 2020/074522

(56) Documents cités:
- WO-A1-2010/135294
- US-A1- 2005 276 425
- US-A1- 2013 142 360
- US-A1- 2014 321 668

## Description

### DOMAINE DE L'INVENTION

La présente invention se rapporte à un procédé de contrôle de la distorsion de haut-parleurs.

Plus particulièrement, la présente invention concerne le contrôle de la distorsion de haut-parleurs embarqués dans un habitacle de véhicule.

### ETAT DE L'ART

On connaît dans l'état de la technique des procédés pour compenser le phénomène de distorsion d'un haut-parleur.

La demande WO 2010/135294 A1 divulgue un système de réglage audio pouvant optimiser l'efficacité de puissance d'un système audio lors de l'exécution d'un réglage automatique du système audio pour optimiser la performance acoustique. Le système peut établir n'importe quel nombre de facteurs de pondération d'efficacité de puissance différents pour fournir un équilibre entre une performance acoustique et une efficacité de puissance lors du fonctionnement. Les facteurs de pondération d'efficacité de puissance peuvent varier de la représentation d'une optimisation de l'efficacité de puissance avec une optimisation contrainte de la performance acoustique à une performance acoustique optimisée avec une considération minimale concernant l'efficacité de puissance. Pour chacun des facteurs de pondération efficaces, le système peut générer des paramètres opérationnels, tels que des paramètres de filtre, pour obtenir une réponse acoustique cible tout en maintenant un certain niveau déterminé en termes d'efficacité de puissance.

La demande de brevet américain US2013/0142360 par exemple divulgue un procédé de contrôle de la distorsion d'un haut-parleur dans lequel le spectre fréquentiel du signal audio est atténué dans une bande de fréquence occasionnant une distorsion importante du signal traversant le haut-parleur.

Toutefois, un tel procédé n'est pas adapté à des haut-parleurs destinés à être embarqués dans un véhicule. En effet, les caractéristiques de distorsion de tels haut-parleurs sont dépendantes de la configuration du véhicule et de leur interface mécanique avec ledit véhicule.

### EXPOSE DE L'INVENTION

L'invention vise à remédier aux inconvénients de l'art antérieur en proposant un procédé de contrôle de la distorsion d'un système de haut-parleurs embarqué dans un véhicule, par exemple une voiture.

L'invention concerne un procédé de contrôle de la distorsion engendrée par un système d'au moins un haut-parleur selon la revendication 1.

Dans un mode de mise en œuvre, au cours de l'étape de mesure :
- un signal d'excitation est envoyé au système de haut-parleurs ;
- une réponse dudit système de haut-parleurs est captée au moyen d'au moins un microphone disposé dans le véhicule ;
un balayage fréquentiel étant réalisé sur le signal d'excitation pour connaître la réponse du système de haut-parleurs sur la plage de fréquences d'intérêt et déterminer l'au moins un indicateur de distorsion du système de haut-parleurs sur cette plage de fréquences d'intérêt.

Dans un mode de mise en œuvre, la plage de fréquences d'intérêt comporte la plage de fréquences allant de 20 Hz à 60 Hz.

Dans un mode de mise en œuvre, deux microphones sont utilisés au cours de l'étape de mesure.

Selon l'invention, les microphones sont placés dans le véhicule de telle sorte que, pour chaque fréquence correspondant à un mode acoustique de la voiture, une position d'au moins un microphone permet d'éviter les nœuds dudit mode acoustique.

Dans un mode de mise en œuvre, au cours de l'étape de détermination du seuil de distorsion acceptable, ledit seuil est fixé par ajustement par un opérateur pour chaque indicateur de distorsion en tenant compte de la nature du signal audio destiné à être envoyé au système de haut-parleurs lors de son utilisation, et ou du rendu souhaité, et ou du degré de distorsion accepté.

Selon l'invention, un filtre est déterminé au cours de l'étape de génération pour chaque niveau de volume d'un autoradio du véhicule afin d'obtenir, pour ledit niveau de volume, et pour chaque fréquence, une amplitude du signal audio inférieure à l'amplitude maximale acceptable à cette fréquence.

Selon l'invention, le spectre du signal audio est analysé au cours de l'étape de génération afin de déterminer un filtre permettant d'obtenir pour chaque fréquence une amplitude du signal audio inférieure à l'amplitude maximale acceptable à cette fréquence, ladite analyse spectrale étant réalisée à intervalles réguliers, et le filtre étant adapté en conséquence.

Selon l'invention, les filtres sont du type passe-haut, low-shelf, peak, ou issus d'une combinaison quelconque de ces types de filtre.

L'invention concerne également un dispositif de contrôle de la distorsion engendrée par un système d'au moins un haut-parleur selon la revendication 5.

### BREVE DESCRIPTION DES FIGURES

L'invention sera mieux comprise à la lecture de la description qui suit et à l'examen des figures qui l'accompagnent. Celles-ci ne sont présentées qu'à titre indicatif et nullement limitatif de l'invention.
La figure 1 représente les différentes étapes du procédé selon l'invention.
La figure 2 représente un modèle simplifié du haut-parleur au cours de l'étape de mesure, au cours de laquelle un signal d'excitation sinusoïdal est envoyé en entrée du haut-parleur et un ensemble d'indicateurs de distorsion sont mesurés.
La figure 3 représente quatre courbes du taux de distorsion harmonique totale pour quatre amplitudes différentes du signal d'excitation.
La figure 4A représente une configuration des microphones lors de l'étape de mesure dans un mode de mise en œuvre.
La figure 4B représente une configuration des microphones lors de l'étape de mesure dans un mode alternatif de mise en œuvre.
La figure 4C représente une configuration des microphones lors de l'étape de mesure dans un mode alternatif de mise en œuvre.
La figure 5A représente d'une part une amplitude maximale acceptable en fonction de la fréquence en entrée du haut-parleur, et d'autre part un ensemble de filtres de type passe-haut à appliquer au signal d'entrée en fonction du niveau de volume de l'autoradio du véhicule.
La figure 5B représente d'une part une amplitude maximale acceptable en fonction de la fréquence en entrée du haut-parleur, et d'autre part un ensemble de filtres de type low-shelf à appliquer au signal d'entrée en fonction du niveau de volume de l'autoradio du véhicule.
La figure 6A représente l'étape de génération des filtres dans un premier mode de mise en œuvre.
La figure 6B représente l'étape de génération des filtres dans un second mode de mise en œuvre.

### DESCRIPTION DETAILLEE

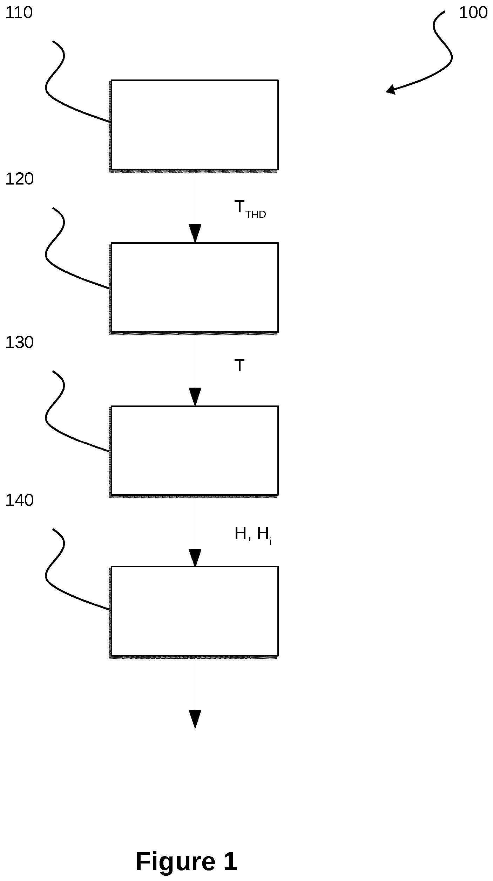

En référence à la figure 1, la présente invention se rapporte à un procédé 100 de contrôle de la distorsion d'un haut-parleur 1 d'un véhicule 2, en particulier une voiture.

Selon l'invention, le procédé 100 comporte :
- une étape de mesure 110 d'un indicateur de distorsion non-linéaire du haut-parleur ;
- une étape de détermination 120 d'un seuil de distorsion acceptable ;
- une étape de génération 130 d'un ensemble de filtres ;
- une étape de correction 140 du signal.

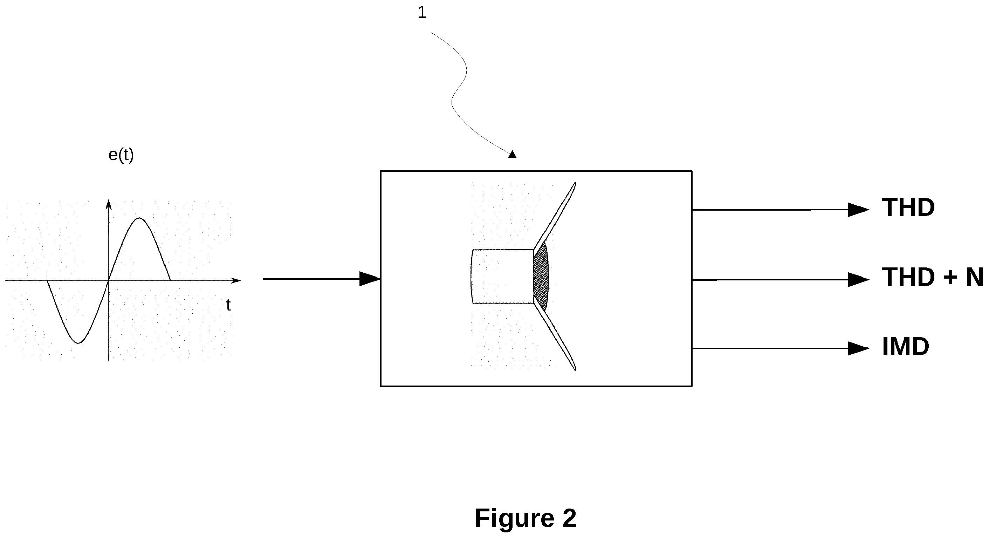

En référence à la figure 2, au cours de l'étape de mesure 110, un indicateur de distorsion non-linéaire du haut-parleur est mesuré. L'indicateur de distorsion non-linéaire peut par exemple être un taux T_{THD} de distorsion harmonique totale THD (*Total Harmonic Distortion* en terminologie anglo-saxonne), un taux T_{THD+N} de distorsion résiduelle THD+N (*Total Harmonic Distortion plus Noise* en terminologie anglo-saxonne), ou encore un taux T_{IMD} de distorsion intermodulation IMD (*Inter-Modulation Distortion* en terminologie anglo-saxonne). Il est considéré dans la suite de la description le taux T_{THD} de distorsion harmonique totale THD, mais l'invention peut bien entendu être adaptée à des indicateurs de distorsion résiduelle THD+N, de distorsion intermodulation IMD, une combinaison de ces indicateurs, ou encore d'autres indicateurs de distorsion non mentionnés ici.

La mesure du taux T_{THD} de distorsion harmonique totale THD est réalisée en excitant le haut-parleur 1 par un signal d'entrée e(t) sinusoïdal de fréquence f₀ appelée fréquence fondamentale, et d'amplitude A. On entend par « signal d'entrée » le signal électrique entrant dans le haut parleur. Dans le cadre de l'étape de mesure 110, le signal d'entrée est appelé « signal d'excitation ». L'excitation du haut-parleur 1 par le signal d'excitation e(t) génère une onde acoustique dans un habitacle du véhicule 2, lequel est fermé. Un microphone M1 placé dans ledit habitacle capte ladite onde acoustique et génère un signal de sortie s(t). Le signal de sortie s(t) est un signal électrique généré par le microphone M1 en réponse à la captation de l'onde acoustique dans l'habitacle, et tient compte en conséquence des phénomènes acoustiques relatifs à l'environnement du haut-parleur et du microphone, par exemple propagation dans l'air et réverbération.

Du fait des non-linéarités du haut-parleur 1, celui-ci génère des harmoniques correspondant à des fréquences multiples entiers de la fréquence fondamentale f₀.

Le taux T_{THD} de distorsion harmonique totale THD est alors mesuré grâce à la relation : ${T}_{THD} = 100 \times \frac{\sqrt{{\sum }_{n = 2}^{M} {V}_{e , n}^{2}}}{{V}_{e , 1}^{2}}$ Où :
- *V_{e,n}* désigne la valeur efficace de l'harmonique de rang n, l'harmonique de rang 1 correspondant à la fréquence fondamentale f₀ ;
- *M* désigne le rang de l'harmonique le plus élevé pris en compte dans le calcul du taux T_{THD} de distorsion harmonique totale. La valeur de M peut par exemple prendre en compte que les effets de la distorsion ne sont plus perceptibles par un individu au-delà de 20kHz. Ainsi, M peut par exemple être tel que *M* × *f*₀ ≤ 20 000 et (*M* + 1) × *f*₀ > 20 000.

Le taux T_{THD} de distorsion harmonique totale est exprimé en pourcentage.

Le taux T_{THD} de distorsion harmonique totale est calculé sur une plage de fréquences f d'intérêt [fₘᵢₙ ;fₘₐₓ] comprise entre une fréquence minimale fₘᵢₙ et une fréquence maximale fₘₐₓ en faisant varier la fréquence fondamentale f₀ du signal d'excitation e(t), par balayage en fréquence continu ou discret sur cette plage de fréquences d'intérêt.

Les non-linéarités du haut-parleur apparaissent de manière notable aux basses fréquences, en général pour des fréquences inférieures à 150 Hz, ces non-linéarités étant plus ou moins marquées selon le haut-parleur considéré. Dans un mode de mise en œuvre préféré du procédé selon l'invention, la plage de fréquences d'intérêt [fₘᵢₙ ;fₘₐₓ] considérée comporte la plage de fréquences allant de 20 Hz à 60 Hz, ce qui correspond à une plage de fréquences pour laquelle les non-linéarités sont particulièrement importantes, quel que soit le haut-parleur considéré.

Le taux T_{THD} de distorsion harmonique totale est déterminé sur la plage de fréquences d'intérêt pour une gamme d'amplitudes A du signal d'excitation comprise entre une première amplitude et une deuxième amplitude, par exemple entre -40 dB et 0 dB.

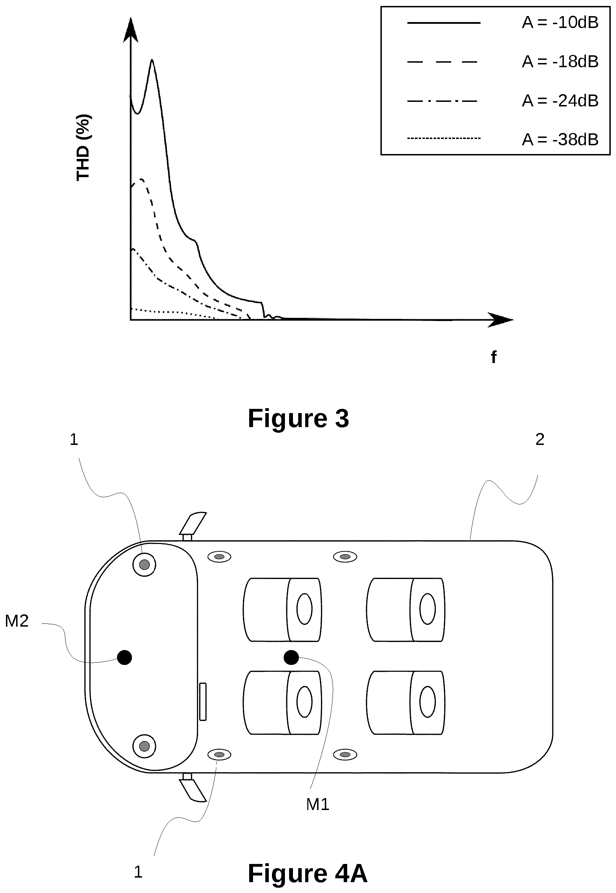

La figure 3 représente quatre exemples de courbe illustrant une évolution du taux T_{THD} de distorsion harmonique totale en fonction de la fréquence f, obtenues à l'issue de l'étape de mesure 110.

La courbe en trait plein correspond à une amplitude A du signal d'entrée e(t) égale à -10dB.

La courbe en trait interrompu correspond à une amplitude A du signal d'entrée e(t) égale à -18dB.

La courbe en trait mixte correspond à une amplitude A du signal d'entrée e(t) égale à -24dB.

La courbe en trait pointillé correspond à une amplitude A du signal d'entrée e(t) égale à -38B.

L'étape de mesure 110 est réalisée *in situ,* dans l'habitacle du véhicule fermé, ce qui permet de tenir compte des caractéristiques de l'habitacle, notamment ses dimensions ou les propriétés acoustiques des objets disposés dans celui-ci (sièges, levier de vitesse,...), ou encore des interactions mécaniques entre le haut-parleur 1 et son environnement.

En pratique, le balayage fréquentiel peut entraîner, pour certaines fréquences particulières, une excitation des modes propres du véhicule 2, entraînant une apparition d'ondes stationnaires et des différences sensiblement importantes d'amplitudes des ondes de pression dans le volume de l'habitacle pour ces fréquences d'un point de l'espace à un autre. En particulier, il apparaît pour ces fréquences des ventres et des nœuds, correspondant à des zones de l'espace où une amplitude de pression atteint respectivement un maximum et un minimum local. En conséquence, le microphone M1 placé en un nœud au niveau duquel les variation de la pression de l'onde acoustique sont très faibles, c'est-à-dire susceptibles de ne pas être perçues à la mesure car masquées par un bruit de mesure et/ou un bruit ambiant, ne permet pas de réaliser une mesure fiable du taux T_{THD} de distorsion harmonique totale.

En conséquence, il est préférentiellement utilisé un nombre de microphones supérieur ou égal à deux. Une configuration des microphones dans l'habitacle est telle que si l'un des microphones se trouve dans un nœud pour une excitation donnée du haut-parleur 1, un autre microphone se trouvera en-dehors des nœuds et le signal capté par cet autre microphone peut être utilisé pour la détermination du taux T_{THD} de distorsion harmonique totale.

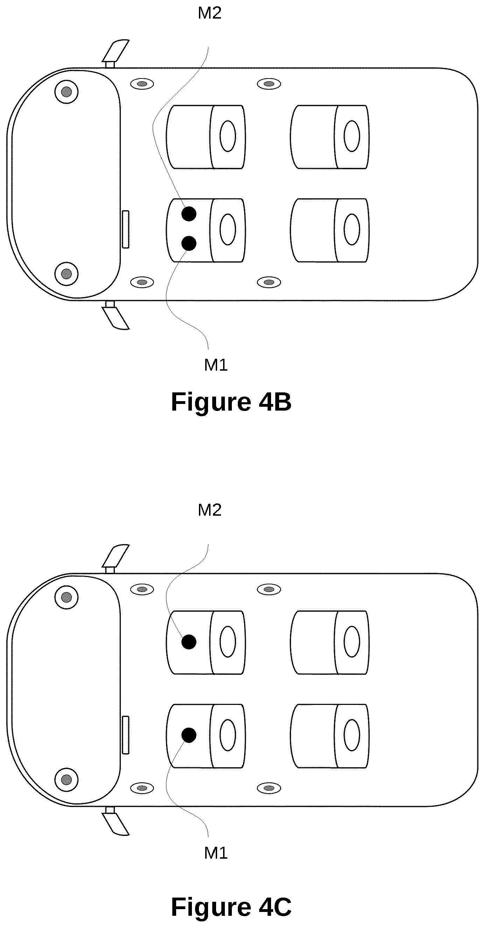

Les figures 4A, 4B et 4C illustrent trois configurations possibles pour un ensemble de deux microphones M1, M2 disposés dans l'habitacle du véhicule 2. Ces trois configurations permettent de déterminer le taux T_{THD} de distorsion harmonique totale au moins sur une plage de fréquences d'intérêt allant de 20 Hz à 1 kHz.

Dans la configuration de la figure 4A, un premier microphone M1 est disposé entre les sièges avant de la voiture, conducteur et passager. Un second microphone M2 est disposé entre le tableau de bord du véhicule et le pare-brise avant.

Dans la configuration de la figure 4B, le premier microphone M1 et le second microphone M2 sont disposés sur l'assise du siège conducteur.

Dans la configuration de la figure 4C, le premier microphone M1 est disposé sur l'assise du siège conducteur tandis que le second microphone M2 est disposé sur l'assise du siège passager avant.

Bien entendu, d'autres configurations peuvent être envisagées, et d'autres microphones peuvent être utilisés.

Au cours de l'étape de détermination 120, un seuil T de distorsion acceptable est fixé. Le seuil de distorsion acceptable correspond à une valeur minimale de l'indicateur de distorsion non-linéaire, ici le taux de distorsion harmonique totale, au-delà de laquelle la correction de la distorsion est appliquée selon le procédé 100 de l'invention, et en-deçà de laquelle aucune correction n'est apportée. Si l'indicateur est égal au seuil de distorsion acceptable, il peut être choisi suivant les cas de réaliser une correction ou non.

La détermination du seuil de distorsion acceptable est arbitraire, mais dépend en grande partie de la nature du signal destiné à être envoyé au haut-parleur 1 lors de son utilisation, ainsi que du rendu souhaité. En effet, comme il sera compris par la suite, la correction de distorsion selon l'invention atténue une partie du spectre fréquentiel du signal d'entrée e(t), en conséquence, plus le seuil T de distorsion est bas, moins le rendu est fidèle en sortie du haut-parleur, après traitement du signal, pour des niveaux de volume élevés. On appelle « niveau de volume » le niveau de volume réglé par le biais d'un autoradio transmettant les signaux audio au haut-parleur. Ainsi, plus le seuil de distorsion est faible, moins il est possible d'augmenter le volume global du signal audio sans le dénaturer. Ainsi, pour un niveau de volume et un seuil de distorsion acceptable donnés, une musique de type électro, présentant un spectre fréquentiel important dans les basses fréquences, sera plus rapidement dénaturé par le traitement réalisé par le procédé 100 en cas d'augmentation du volume qu'une musique de type classique présentant un spectre fréquentiel plus pauvre en basses fréquences. Il convient donc d'ajuster le seuil en fonction du niveau maximal souhaité en sortie de haut-parleur et en fonction du degré de distorsion toléré.

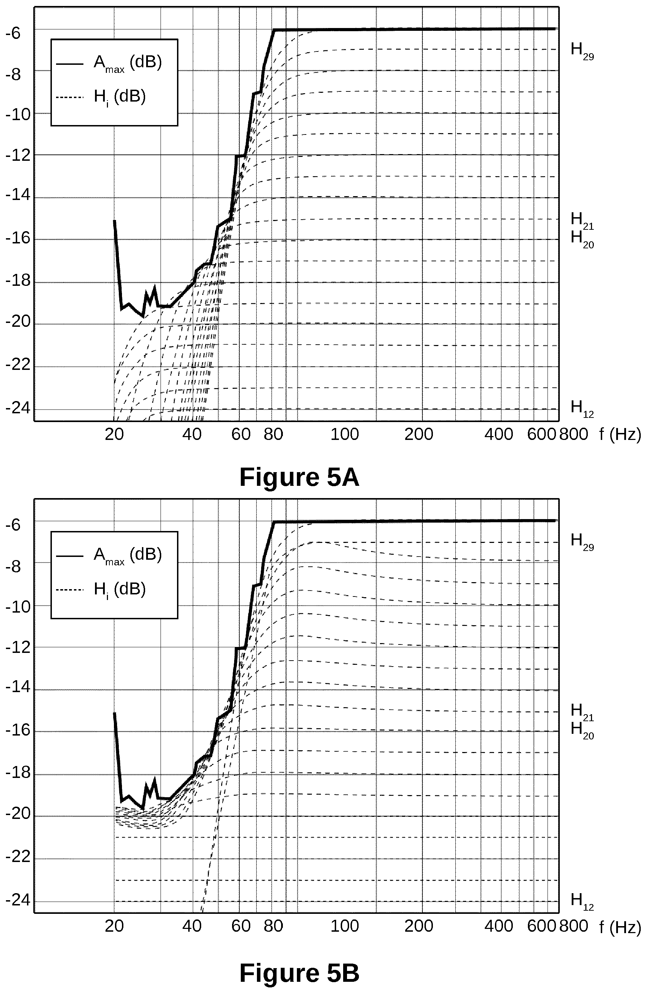

Sur chacune des figures 5A et 5B, la courbe en trait plein illustre une amplitude Aₘₐₓ maximale du signal d'entrée e(t) du haut-parleur 1 acceptable en fonction de la fréquence, c'est-à-dire au-delà de laquelle il est obtenu un taux de distorsion harmonique totale supérieure à la valeur seuil fixée lors de l'étape de détermination 120 du seuil de distorsion acceptable.

A titre d'exemple, pour le cas illustré sur les figures 5A et 5B, un niveau sonore de -12dB à 50Hz conduit à une valeur du taux T_{THD} de distorsion harmonique totale égal à la valeur seuil T à la même fréquence.

Au cours de l'étape de génération 130, au moins un filtre destiné à être appliqué au signal d'entrée e(t) avant son passage dans le haut-parleur est déterminé. Le signal d'entrée considéré ici et au cours de l'étape suivante est appelée « signal audio », et peut être de manière générale n'importe quel type de signal sonore, en particulier de type musique provenant par exemple d'un CD-ROM ou d'une clé USB.

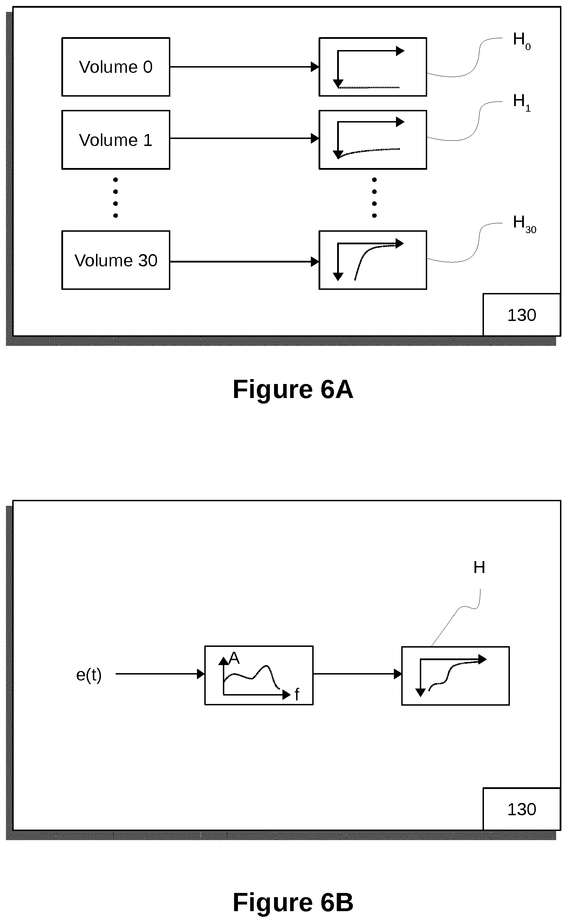

Dans un premier mode de mise en œuvre illustré sur la figure 6A, il est déterminé un filtre Hᵢ pour chaque niveau de volume i de l'autoradio, ledit niveau de volume i évoluant par exemple sur une échelle allant de 0 à 30 inclus. Les filtres Hᵢ générés permettent, pour un niveau de volume donné de l'autoradio, d'obtenir pour chaque fréquence une amplitude du signal audio inférieure à l'amplitude maximale Aₘₐₓ acceptable.

Dans la mesure où la distorsion est plus marquée aux basses fréquences, les filtres retenus permettent avantageusement d'atténuer les basses fréquences et sont par exemple du type passe-haut, low-shelf, peak ou issus d'une combinaison de ces trois types de filtres. Sur les figures 5A et 5B, les filtres Hᵢ générés sont représentés par des traits interrompus et sont respectivement du type passe-haut d'ordre quatre et low-shelf de facteur de qualité 1,8.

Préférentiellement, plusieurs types de signaux d'entrée sont considérés pour générer ces filtres, par exemple des musiques de type classique, électro, rock, pop, hip/hop, jazz,... et, pour chaque type de musique et chaque niveau de volume de l'autoradio, le filtre permettant de ne pas dépasser l'amplitude maximale Aₘₐₓ est déterminé. Le filtre retenu en dernier lieu pour un niveau de volume donné est issu d'une combinaison des filtres déterminés pour chacun des types de musique, permettant, pour chaque fréquence et chaque type de musique, de ne pas dépasser l'amplitude maximale Aₘₐₓ en entrée de haut-parleur.

Dans ce premier mode de mise en œuvre, l'ensemble des filtres est donc généré avant utilisation de l'autoradio par un utilisateur.

Le signal audio est ensuite corrigé au cours de l'étape de correction 140 lorsque l'utilisateur utilise l'autoradio.

Il est appliqué au signal audio, en amont du haut-parleur, le filtre Hᵢ correspondant au niveau de volume i réglé par l'utilisateur. Le signal filtré, ou signal audio corrigé, est envoyé au haut-parleur.

Dans ce premier mode de mise en œuvre, le filtre est dit « statique » et ne varie pas tant qu'un utilisateur ne modifie pas le volume de l'autoradio.

Dans un second mode de mise en œuvre de l'invention illustré sur la figure 6B, une analyse spectrale du signal audio est réalisée en temps réel, au cours de l'étape de génération 130, pendant l'utilisation de l'autoradio par l'utilisateur. Un filtre H est généré à partir du résultat de cette analyse. Le filtre est déterminé de telle sorte qu'il permet pour chaque fréquence d'obtenir en sortie du filtre une amplitude A du signal audio e(t) inférieure à l'amplitude Aₘₐₓ maximale acceptable.

A titre d'exemple, en notant T(f₁) le seuil de distorsion acceptable à une fréquence particulière f₁, si l'amplitude A(f₁) du signal d'entrée est égale à T(f₁)+3dB, la valeur du filtre H(f₁) en f₁ doit être inférieure ou égale à -3dB.

Le signal audio est ensuite corrigé au cours de l'étape de correction 140. Le filtre H est appliqué au signal avant son entrée dans le haut-parleur. Le signal filtré, ou signal audio corrigé, est envoyé au haut-parleur.

Dans ce mode de mise en œuvre, le filtre H peut ainsi être actualisé à intervalles temporels réguliers, par exemple toutes les vingt millisecondes. Le filtre est dit « dynamique » et évolue en temps réel pour s'adapter au signal.

Un avantage de ce mode de mise en œuvre est qu'il tient compte des variations du spectre fréquentiel au cours du temps du signal audio envoyé vers le haut-parleur 1.

Un avantage du premier mode de mise en œuvre est qu'il demande moins de ressources que le second mode de mise œuvre et sa complexité est moindre dans la mesure où il suffit d'appliquer un filtre prédéterminé en fonction du niveau de volume de l'autoradio.

Bien qu'il n'ait été considéré qu'un seul haut-parleur, l'invention peut aussi s'appliquer à un système de plusieurs haut-parleurs. Dans ce cas-là, il conviendra de considérer pour la génération et l'application des filtres, pour chaque fréquence, le haut-parleur générant le plus de distorsion. L'amplitude maximale Aₘₐₓ acceptable dépend, à une fréquence donnée, du haut-parleur dimensionnant, c'est-à-dire celui générant le plus de distorsion à cette fréquence, le haut-parleur dimensionnant pouvant être différent d'une fréquence à une autre.

Egalement, l'invention peut être appliquée *mutatis mutandis* à un autre indicateur de distorsion non-linéaire, par exemple le taux T_{THD+N} de distorsion résiduelle THD+N, ou encore le taux T_{IMD} de distorsion intermodulation IMD. Il est également possible de considérer ces indicateurs en parallèle et de fixer un seuil de distorsion pour chaque indicateur de distorsion non-linéaire. L'ensemble de filtres doit être établi de manière à ne pas dépasser, pour chaque fréquence, le seuil de valeur minimale.

## Revendications

1. Procédé (100) de contrôle de la distorsion engendrée par un système d'au moins un haut-parleur (1) embarqué dans un véhicule (2) et destiné à recevoir un signal audio, comportant :
- une étape de mesure (110) d'au moins un indicateur de distorsion de l'au moins un haut-parleur, au cours de laquelle étape de mesure un signal d'excitation est envoyé au système de haut-parleurs (1), une réponse dudit système de haut-parleurs est captée au moyen d'au moins un microphone (M1, M2) disposé dans le véhicule (2), un balayage fréquentiel étant réalisé sur le signal d'excitation pour connaître la réponse du système de haut-parleurs sur une plage de fréquences d'intérêt [fₘᵢₙ ; fₘₐₓ] et déterminer l'au moins un indicateur de distorsion du système de haut-parleurs sur cette plage de fréquences d'intérêt, l'au moins un microphone (M1, M2) étant disposé dans le véhicule de telle sorte que, pour chaque fréquence correspondant à un mode acoustique de la voiture, une position d'au moins un microphone permet d'éviter les nœuds dudit mode acoustique ;
- une étape de détermination (120) d'un seuil de distorsion acceptable pour chaque indicateur de distorsion, permettant de déterminer une amplitude maximale (Aₘₐₓ) acceptable pour chaque fréquence f de la plage de fréquences d'intérêt [fₘᵢₙ ; fₘₐₓ] du signal audio en entrée du système de haut-parleur au-delà de laquelle amplitude maximale au moins un indicateur de distorsion dépasse le seuil de distorsion qui lui est associé ;
- une étape de génération (130) d'un ensemble d'au moins un filtre (H, Hᵢ) destiné à être appliqué au signal audio, permettant d'obtenir, pour chaque fréquence f de la plage de fréquences d'intérêt dudit signal audio, une amplitude du signal audio inférieure à l'amplitude maximale (Aₘₐₓ) acceptable ;
- une étape de correction (140) du signal audio en entrée du système de haut-parleurs par application d'au moins un filtre (H, Hᵢ) déterminé à l'étape de génération (130) au signal audio ;
procédé au cours duquel l'au moins un filtre (Hᵢ) est déterminé au cours de l'étape de génération (130) pour chaque niveau de volume i d'un autoradio du véhicule ;
procédé au cours duquel une analyse spectrale du signal audio est réalisée au cours de l'étape de génération (130) afin de déterminer l'au moins un filtre (H, Hi), ladite analyse spectrale étant réalisée à intervalles réguliers, et l'au moins un filtre (H, Hi) étant adapté en conséquence ; et
dans lequel les filtres sont du type passe-haut, low-shelf, peak, ou issus d'une combinaison quelconque de ces types de filtre.

2. Procédé (100) selon la revendication 1 **caractérisé en ce que** la plage de fréquences d'intérêt comporte la plage de fréquences allant de 20 Hz à 60 Hz.

3. Procédé (100) selon la revendication 1 ou la revendication 2 **caractérisé en ce que** deux microphones (M1, M2) sont utilisés au cours de l'étape de mesure (110).

4. Procédé (100) selon l'une quelconque des revendications précédentes **caractérisé en ce que** au cours de l'étape de détermination (120) du seuil de distorsion acceptable, ledit seuil est fixé par ajustement par un opérateur pour chaque indicateur de distorsion en tenant compte de la nature du signal audio destiné à être envoyé au système de haut-parleurs (1) lors de son utilisation, et ou du rendu souhaité, et ou du degré de distorsion accepté.

5. Système de contrôle de la distorsion engendrée par un système d'au moins un haut-parleur (1) embarqué dans un véhicule (2) et destiné à recevoir un signal audio, comportant des moyens pour :
- mesurer au moins un indicateur de distorsion de l'au moins un haut-parleur, pour transmettre un signal d'excitation au système de haut-parleurs (1), capter une réponse dudit système de haut-parleurs au moyen d'au moins un microphone (M1, M2) disposé dans le véhicule (2), réaliser un balayage fréquentiel sur le signal d'excitation afin de connaître la réponse du système de haut-parleurs sur une plage de fréquences d'intérêt [fₘᵢₙ ; fₘₐₓ] et afin de déterminer l'au moins un indicateur de distorsion du système de haut-parleurs sur cette plage de fréquences d'intérêt, l'au moins un microphone (M1, M2) étant disposé dans le véhicule de telle sorte que, pour chaque fréquence correspondant à un mode acoustique de la voiture, une position d'au moins un microphone permet d'éviter les nœuds dudit mode acoustique ;
- déterminer un seuil de distorsion acceptable pour chaque indicateur de distorsion, permettant de déterminer une amplitude maximale (Aₘₐₓ) acceptable pour chaque fréquence f de la plage de fréquences d'intérêt [fₘᵢₙ ; fₘₐₓ] du signal audio en entrée du système de haut-parleur au-delà de laquelle amplitude maximale au moins un indicateur de distorsion dépasse le seuil de distorsion qui lui est associé ;
- générer un ensemble d'au moins un filtre (H, Hi) destiné à être appliqué au signal audio, permettant d'obtenir, pour chaque fréquence f de la plage de fréquences d'intérêt dudit signal audio, une amplitude du signal audio inférieure à l'amplitude maximale (Aₘₐₓ) acceptable ;
- corriger le signal audio en entrée du système de haut-parleurs par l'application d'au moins un filtre au signal audio, ledit au moins un filtre appliqué ayant été déterminé par les moyens pour générer (130) l'ensemble d'au moins un filtre ; l'au moins un filtre (Hᵢ) étant déterminé pour chaque niveau de volume i d'un autoradio du véhicule ;
- -des moyens pour réaliser une analyse spectrale du signal audio afin de déterminer l'au moins un filtre (H), ladite analyse spectrale étant réalisée à intervalles réguliers, et l'au moins un filtre (H) étant adapté en conséquence ; et
dans lequel les filtres sont du type passe-haut, low-shelf, peak, ou issus d'une combinaison quelconque de ces types de filtre.

## Patentansprüche

1. Verfahren (100) zur Steuerung der Verzerrung, die durch ein System aus mindestens einem Lautsprecher (1) erzeugt wird, das in einem Fahrzeug (2) eingebaut ist und zum Empfangen eines Audiosignals bestimmt ist, aufweisend das Folgende:
- einen Messschritt (110) von mindestens einem Verzerrungsindikator des mindestens einen Lautsprechers, wobei während dem Messschritt ein Anregungssignal an das Lautsprechersystem (1) gesendet wird, eine Antwort des Lautsprechersystems mittels mindestens eines im Fahrzeug (2) angeordneten Mikrofons (M1, M2) erfasst wird, wobei eine Frequenzabtastung am Anregungssignal durchgeführt wird, um die Antwort des Lautsprechersystems auf einen Frequenzbereich von Interesse [fₘᵢₙ; fₘₐₓ] zu ermitteln und den mindestens einen Verzerrungsindikator des Lautsprechersystems über diesen Frequenzbereich von Interesse zu bestimmen, wobei das mindestens eine Mikrofon (M1, M2) im Fahrzeug so angeordnet ist, dass für jede Frequenz, die einem akustischen Modus des Fahrzeugs entspricht, eine Position von mindestens einem Mikrofon es ermöglicht, die Knoten des akustischen Modus zu vermeiden;
- einen Bestimmungsschritt (120) eines Schwellenwerts für akzeptable Verzerrung für jeden Verzerrungsindikator, der es ermöglicht, eine akzeptable maximale Amplitude (Aₘₐₓ) für jede Frequenz f des Frequenzbereichs von Interesse [fₘᵢₙ; fₘₐₓ] des Audiosignals am Eingang des Lautsprechersystems zu bestimmen, wobei oberhalb der maximalen Amplitude mindestens ein Verzerrungsindikator den ihm zugeordneten Verzerrungsschwellenwert überschreitet;
- einen Erzeugungsschritt (130) eines Bausatzes von mindestens einem Filter (H, Hᵢ₎, der auf das Audiosignal angewendet werden soll, wodurch für jede Frequenz f des Frequenzbereichs von Interesse des Audiosignals eine Amplitude des Audiosignals erreicht werden kann, die kleiner ist als die akzeptable maximale Amplitude (Aₘₐₓ);
- einen Korrekturschritt (140) des Audiosignals am Eingang des Lautsprechersystems durch Anwenden mindestens eines Filters (H, Hᵢ) auf das Audiosignal, der in dem Erzeugungsschritt (130) bestimmt wurde;
Verfahren, bei dem während des Erzeugungsschritts (130) für jede Lautstärkestufe i eines Fahrzeugradios der mindestens eine Filter (Hi) bestimmt wird;
Verfahren, bei dem während des Erzeugungsschritts (130) eine spektrale Analyse des Audiosignals durchgeführt wird, um den mindestens einen Filter (H, Hi) zu bestimmen, wobei die spektrale Analyse in regelmäßigen Abständen durchgeführt wird und der mindestens eine Filter (H, Hi) entsprechend angepasst ist; und
wobei die Filter vom Typ Hochpass, Low-Shelf, Peak oder aus einer beliebigen Kombination dieser Filtertypen sind.

2. Verfahren (100) nach Anspruch 1, **dadurch gekennzeichnet, dass** der Frequenzbereich von Interesse den Frequenzbereich von 20 Hz bis 60 Hz aufweist.

3. Verfahren (100) nach Anspruch 1 oder Anspruch 2, **dadurch gekennzeichnet, dass** während des Messschritts (110) zwei Mikrofone (M1, M2) verwendet werden.

4. Verfahren (100) nach einem der vorhergehenden Ansprüche, **dadurch gekennzeichnet, dass** während des Bestimmungsschritts (120) des Schwellenwerts für akzeptable Verzerrung der Schwellenwert durch Anpassen durch einen Bediener für jeden Verzerrungsindikator unter Berücksichtigung der Art des Audiosignals, das bei seiner Verwendung an das Lautsprechersystem (1) gesendet werden soll, und/oder der gewünschten Wiedergabe und/oder des akzeptierten Verzerrungsgrads festgelegt wird.

5. System zur Steuerung der Verzerrung, die durch ein System aus mindestens einem Lautsprecher (1) erzeugt wird, das in einem Fahrzeug (2) eingebaut ist und zum Empfangen eines Audiosignals bestimmt ist, aufweisend Mittel für Folgendes:
- Messen mindestens eines Verzerrungsindikators des mindestens einen Lautsprechers, um ein Anregungssignal an das Lautsprechersystem (1) zu übertragen, Erfassen einer Antwort des Lautsprechersystems mittels mindestens eines im Fahrzeug (2) angeordneten Mikrofons (M1, M2), Durchführen einer Frequenzabtastung am Anregungssignal, um die Antwort des Lautsprechersystems auf einen Frequenzbereich von Interesse [fₘᵢₙ; fₘₐₓ] zu ermitteln und den mindestens einen Verzerrungsindikator des Lautsprechersystems über diesen Frequenzbereich von Interesse zu bestimmen, wobei das mindestens eine Mikrofon (M1, M2) im Fahrzeug so angeordnet ist, dass für jede Frequenz, die einem akustischen Modus des Fahrzeugs entspricht, eine Position von mindestens einem Mikrofon es ermöglicht, die Knoten des akustischen Modus zu vermeiden;
- Bestimmen eines Schwellenwerts für akzeptable Verzerrung für jeden Verzerrungsindikator, der es ermöglicht, eine akzeptable maximale Amplitude (Aₘₐₓ) für jede Frequenz f des Frequenzbereichs von Interesse [fₘᵢₙ; fₘₐₓ] des Audiosignals am Eingang des Lautsprechersystems zu bestimmen, wobei oberhalb der maximalen Amplitude mindestens ein Verzerrungsindikator den ihm zugeordneten Verzerrungsschwellenwert übersteigt;
- Erzeugen eines Bausatzes von mindestens einem Filter (H, Hᵢ), der auf das Audiosignal angewendet werden soll, wodurch für jede Frequenz f des Frequenzbereichs von Interesse des Audiosignals eine Amplitude des Audiosignals erreicht werden kann, die kleiner ist als die akzeptable maximale Amplitude (Aₘₐₓ);
- Korrigieren des Audiosignals am Eingang des Lautsprechersystems durch Anwenden mindestens eines Filters auf das Audiosignal, wobei der mindestens angewendete Filter durch die Mittel zum Erzeugen (130) des Bausatzes von mindestens einem Filter bestimmt wurde;
wobei mindestens ein Filter (Hᵢ) für jede Lautstärkestufe i eines Fahrzeugradios bestimmt wird;
- Mittel zum Durchführen einer spektralen Analyse des Audiosignals, um den mindestens einen Filter (H) zu bestimmen, wobei die spektrale Analyse in regelmäßigen Abständen durchgeführt wird, und der mindestens eine Filter (H) entsprechend angepasst ist; und
wobei die Filter vom Typ Hochpass, Low-Shelf, Peak oder aus einer beliebigen Kombination dieser Filtertypen sind.

## Claims

1. A method (100) for controlling the distortion generated by a system comprising at least one speaker (1) installed in a vehicle (2) and intended to receive an audio signal, comprising:
- a step (110) of measuring at least one distortion indicator of the at least one speaker, during which measurement step an excitation signal is sent to the speaker system (1), a response of said speaker system is picked up by means of at least one microphone (M1, M2) arranged in the vehicle (2), a frequency scan being carried out on the excitation signal in order to ascertain the response of the speaker system over a frequency range of interest [fₘᵢₙ; fₘₐₓ] and to determine the at least one distortion indicator of the speaker system over this frequency range of interest, the at least one microphone (M1, M2) being arranged in the vehicle such that, for each frequency corresponding to an acoustic mode of the automobile, a position of at least one microphone allows avoiding the nodes of said acoustic mode;
- a step (120) of determining an acceptable distortion threshold for each distortion indicator, making it possible to determine a maximum acceptable amplitude (Aₘₐₓ) for each frequency f of the frequency range of interest [fₘᵢₙ; fₘₐₓ] of the audio signal at the input of the speaker system, beyond which maximum amplitude at least one distortion indicator exceeds the distortion threshold associated with it;
- a step (130) of generating a set of at least one filter (H, Hᵢ) intended to be applied to the audio signal, allowing obtaining an amplitude of the audio signal below the maximum acceptable amplitude (Aₘₐₓ) for each frequency f of the frequency range of interest of said audio signal;
- a step (140) of correcting the audio signal at the input of the speaker system by applying at least one filter (H, Hᵢ) determined in the generation step (130) to the audio signal;
during which method the at least one filter (Hi) is determined during the generation step (130) for each volume level i of an automotive head unit of the vehicle;
during which method a spectral analysis of the audio signal is carried out during the generation step (130) in order to determine the at least one filter (H, Hi), said spectral analysis being carried out at regular intervals and the at least one filter (H, Hi) being adapted accordingly; and
wherein the filters are of the high-pass, low-shelf or peak type, or derived from any combination of these filter types.

2. The method (100) as claimed in claim 1, **characterized in that** the frequency range of interest comprises the frequency range extending from 20 Hz to 60 Hz.

3. The method (100) as claimed in claim 1 or claim 2, **characterized in that** two microphones (M1, M2) are used during the measurement step (110).

4. The method (100) as claimed in any one of the preceding claims, **characterized in that** during the step (120) of determining the acceptable distortion threshold, said threshold is set by adjustment by an operator for each distortion indicator while taking into account the nature of the audio signal intended to be sent to the speaker system (1) during its use, and/or the desired rendering, and/or the accepted degree of distortion.

5. A system for controlling the distortion generated by a system comprising at least one speaker (1) installed in a vehicle (2) and intended to receive an audio signal, comprising means for:
- measuring at least one distortion indicator of the at least one speaker, for transmitting an excitation signal to the speaker system (1), picking up a response of said speaker system by means of at least one microphone (M1, M2) arranged in the vehicle (2), and carrying out a frequency scan on the excitation signal in order to ascertain the response of the speaker system over a frequency range of interest [fₘᵢₙ; fₘₐₓ] and in order to determine the at least one distortion indicator of the speaker system over this frequency range of interest, the at least one microphone (M1, M2) being arranged in the vehicle in such a way that, for each frequency corresponding to an acoustic mode of the automobile, a position of at least one microphone makes it possible to avoid the nodes of said acoustic mode;
- determining an acceptable distortion threshold for each distortion indicator, making it possible to determine a maximum acceptable amplitude (Aₘₐₓ) for each frequency f of the frequency range of interest [fₘᵢₙ; fₘₐₓ] of the audio signal at the input of the speaker system, beyond which maximum amplitude at least one distortion indicator exceeds the distortion threshold associated with it;
- generating a set of at least one filter (H, Hᵢ) intended to be applied to the audio signal, allowing obtaining an amplitude of the audio signal below the maximum acceptable amplitude (Aₘₐₓ) for each frequency f of the frequency range of interest of said audio signal;
- correcting the input audio signal of the speaker system by applying at least one filter to the audio signal, said at least one applied filter having been determined by the means for generating (130) the set of at least one filter;
the at least one filter (Hᵢ) being determined for each volume level i of an automotive head unit of the vehicle;
- means for carrying out a spectral analysis of the audio signal in order to determine the at least one filter (H), said spectral analysis being carried out at regular intervals and the at least one filter (H) being adapted accordingly; and
wherein the filters are of the high-pass, low-shelf or peak type, or derived from any combination of these filter types.
